# FASCICULE DE BREVET EUROPEEN

(11) **EP 3 454 368 B1**
(45) Date de publication et mention de la délivrance du brevet: **28.05.2025**
(21) Numéro de dépôt: 18192582.7
(22) Date de dépôt: 04.09.2018
(51) Int. Cl.: H01L 23/58, H01L 25/065, G06K 19/073

(54) **EMPILEMENT DE PUCES PROTEGÉ CONTRE LE PIRATAGE DE DONNÉES**
CHIPSTAPEL, DER GEGEN DATEN-HACKING GESCHÜTZT IST
CHIP STACK PROTECTED AGAINST DATA HACKING

(30) Priorité: 11.09.2017 FR 1758340
(43) Date de publication de la demande: 13.03.2019
(73) Titulaire: STMICROELECTRONICS (ROUSSET) SAS, 13790 Rousset (FR)
(72) Inventeur: SARAFIANOS, Alexandre, 83910 POURRIERES (FR); ORDAS, Thomas, 83470 POURCIEUX (FR)
(74) Mandataire: Cabinet Beaumont

(56) Documents cités:
- EP-A2- 1 273 997
- WO-A1-2009/035688
- WO-A1-2015/000813
- DE-A1- 19 940 759
- US-A1- 2003 008 432
- US-A1- 2006 180 939
- US-A1- 2010 213 590

## Description

La présente demande concerne le domaine des puces électroniques et vise plus particulièrement un empilement de puces comprenant une puce protégée contre des attaques de pirates.

### Exposé de l'art antérieur

Certaines puces électroniques telles que des puces de cartes bancaires peuvent contenir des données confidentielles susceptibles d'être convoitées par des pirates. Ces données confidentielles peuvent être contenues dans des circuits situés du côté de la face avant de la puce. Pour obtenir ces données, un pirate peut mener une attaque à partir de la face arrière ou de la face avant de la puce.

Dans un type d'attaque, dit attaque par gravure, le pirate grave une partie de la face arrière de la puce. A partir de cette partie gravée, le pirate grave des cavités de quelques micromètres de largeur, par exemple en utilisant un faisceau d'ions, qui s'étendent vers la face avant jusqu'au niveau des circuits. Des contacts électriques avec des éléments des circuits sont ensuite créés dans ces cavités, et le pirate utilise ces contacts pour analyser la puce en fonctionnement.

Dans un autre type d'attaque, le pirate balaye la puce par des impulsions laser. L'impact du faisceau laser perturbe le fonctionnement de la puce. C'est l'observation des conséquences de ces perturbations sur l'activité des circuits qui permet au pirate de mener à bien son attaque. Pour perturber le fonctionnement de la puce, le pirate peut aussi appliquer des potentiels positifs ou négatifs au moyen d'une sonde en contact avec la puce, ou induire des courants ou des tensions dans des éléments des circuits au moyen d'une bobine disposée à proximité de la puce. Ce type d'attaque est appelé attaque par injection de faute.

Dans un autre type d'attaque, le pirate utilise le rayonnement électromagnétique émis par la puce de manière à obtenir les données confidentielles. En effet, les commutations des portes logiques constituant un circuit produisent des émissions électromagnétiques. Or, dans un circuit, toutes les portes logiques ne commutent pas à chaque cycle d'horloge et donc les émissions électromagnétiques seront proportionnelles au nombre de portes logiques commutant. Grâce à l'utilisation de certains algorithmes d'analyse mathématique (distance de Hamming...), il est possible de retrouver la clé de chiffrement de la puce en se basant sur une analyse des variations des émissions électromagnétiques du circuit.

Les détecteurs d'attaques connus présentent tous un ou plusieurs des inconvénients suivants. Certains ne permettent de détecter qu'un nombre limité de type d'attaques, souvent un seul. Certains sont visibles pour le pirate. L'ajout de certains détecteurs entraine des modifications dans le procédé de fabrication. Des détecteurs d'attaques sont connus des documents WO 2015/000813 A1 et DE 199 40 759 A1.

Plus particulièrement, le premier document montre un empilement de puces comprenant:
une puce principale contenant des composants à protéger; et
une puce auxiliaire en regard d'une face de la puce principale, une zone de la puce auxiliaire en regard des composants à protéger comprenant au moins une piste conductrice isolée formant un motif serré en regard des composants à protéger, les extrémités de ladite au moins une piste conductrice étant accessibles au niveau de la puce principale.

Le deuxième document montre un empilement de puces comprenant :
une puce principale contenant des composants à protéger ; et
une puce auxiliaire en regard de chaque face de la puce principale, une zone de chaque puce auxiliaire en regard des composants à protéger comprenant un plan métallique.

### Résumé

Un mode de réalisation pallie tout ou partie des inconvénients des puces électroniques usuelles protégées contre des attaques.

Ainsi, un mode de réalisation prévoit un empilement de puces selon la revendication comprenant : une puce principale contenant des composants à protéger ; et une puce auxiliaire en regard de chaque face de la puce principale, la zone de chaque puce auxiliaire en regard des composants à protéger comprenant un plan métallique connecté à la masse, et au moins une piste conductrice isolée formant un motif serré en regard des composants à protéger, les extrémités de ladite au moins une piste conductrice étant accessibles au niveau de la puce principale, le plan métallique de chaque puce auxiliaire étant situé entre la puce principale et la piste conductrice de ladite puce auxiliaire.

Selon un mode de réalisation, le motif formé par les pistes conductrices est un serpentin.

Selon un mode de réalisation, le motif formé par les pistes conductrices est une spirale.

Selon un mode de réalisation, une extrémité d'une piste conductrice d'une puce auxiliaire est connectée à une extrémité d'une piste conductrice de l'autre puce auxiliaire.

Selon un mode de réalisation, le dispositif est adapté à détecter une interruption de la connexion entre les pistes conductrices.

Selon un mode de réalisation, les pistes conductrices sont connectées à un dispositif adapté à détecter des interruptions des pistes conductrices.

Selon un mode de réalisation, les puces auxiliaires sont fixées à la puce principale par des billes métalliques.

Selon un mode de réalisation, les puces auxiliaires comprennent des composants électroniques.

Selon un mode de réalisation, le plan métallique de chaque puce auxiliaire s'étend sur toute la surface de la puce auxiliaire correspondante.

Selon un mode de réalisation, les dimensions d'une des puces auxiliaires sont inférieures à celles de l'autre puce auxiliaire.

Un mode de réalisation prévoit un procédé de protection de composants d'une puce principale contenant des composants à protéger, le procédé selon la revendication indépendante 11 comprenant les étapes suivantes : prévoir des puces auxiliaires comprenant chacune un plan métallique connecté à la masse, et au moins une piste conductrice isolée formant un motif serré ; monter les puces auxiliaires de part et d'autre de la puce principale de telle manière que les plans métalliques et les pistes conductrices soient en regard des composants à protéger, le plan métallique de chaque puce auxiliaire étant situé entre la puce principale et la piste conductrice de ladite puce auxiliaire ; connecter les extrémités des pistes conductrices avec la puce principale.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, schématique, d'un mode de réalisation d'un empilement de puces comprenant une puce protégée ; et
les figures 2 et 3 sont des vues en perspective, schématiques et simplifiées, d'exemples de mise en oeuvre de pistes conductrices.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, les composants des différentes puces ne sont pas décrits en détail.

Sauf précision contraire, le terme "sensiblement" signifie à 10 % près, de préférence à 5 % près.

L'expression "interruption d'une piste conductrice" doit être comprise comme signifiant soit une interruption totale de la piste soit une interruption partielle, résultant en modification de la résistance de la piste.

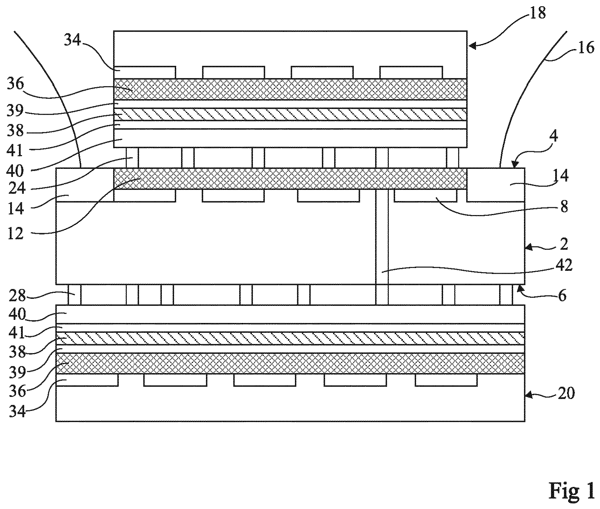

La figure 1 est une vue en coupe schématique d'un mode de réalisation d'un empilement de puces comprenant une puce principale 2. La puce principale 2 a une première face 4 et une seconde face 6.

La puce principale 2 comporte, du côté de la première face 4, des composants électroniques à protéger 8 contenant des données confidentielles. Les données confidentielles sont par exemple des données bancaires, des données personnelles ou des clés de cryptage.

La puce 2 comprend, de plus, un réseau d'interconnexion 12 recouvrant les composants 8. Le réseau d'interconnexion 12 est constitué de niveaux de métallisation, non représentés, connectés entre eux, et aux composants 8 de la puce, par des vias conducteurs, non représentés.

La puce principale 2 comprend en outre des plots de contact 14. Dans la figure 1, les plots de contact 14 sont situés à la périphérie de la puce 2 et sont susceptibles d'être connectés par des fils conducteurs 16 à des circuits extérieurs, par exemple des sources de tension, des sources de signaux d'horloge ou des bornes entrées/sorties.

Des puces auxiliaires 18 et 20 peuvent contenir chacune des composants électroniques 34. Les composants 34 ne contiennent pas de données confidentielles et il n'est pas nécessaire de les protéger contre des attaques de pirates. Chaque puce 18 ou 20 comprend alors un réseau d'interconnexion 36 recouvrant les composants 34 et les connectant entre eux.

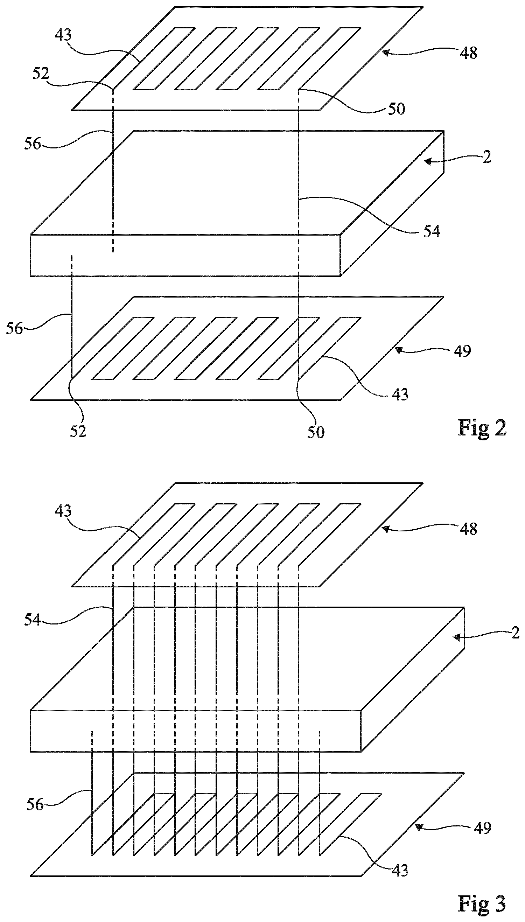

Chaque réseau d'interconnexion 36 est recouvert d'une couche isolante 38 contenant au moins une piste conductrice non représentée en figure 1 s'étendant en regard des composants à protéger. Chaque réseau 36 est séparé de la piste conductrice par une couche isolante 39. Les pistes conductrices seront décrites plus en détail en relation avec les figures 2 et 3.

La couche 38 de chaque puce 18 et 20 est recouverte, d'un plan métallique 40 connecté à la masse. Chaque plan métallique 40 est séparé de la couche 38 associée par une couche isolante 41. Chaque plan métallique 40 s'étend au moins sur la zone située en regard des composants 8 à protéger. Chaque plan métallique 40 s'étend, par exemple, sur toute la puce 18 ou 20.

Les plans métalliques 40 sont par exemple en cuivre ou en aluminium et ont une épaisseur par exemple comprise entre 1 et 5 µm.

Les puces auxiliaires 18 et 20 sont situées de chaque côté de la puce principale 2. Les puces 18 et 20 sont situées de telle manière que le plan métallique 40 de la puce 18 est en regard de la première face 4 de la puce 2 et que le plan métallique 40 de la puce 20 est en regard de la seconde face 6 de la puce 2. La puce 18 est fixée à la puce 2 par des éléments métalliques 24 et la puce 20 est fixée à la puce 2 par des éléments métalliques 28.

Les éléments métalliques 24 et 28 sont par exemple des billes métalliques reliant des plots, non représentés, des puces 18 et 20 à des plots de la puce 2. La hauteur des éléments 24 et 28, correspondant à la distance entre la puce 18 ou la puce 20 et la puce 2, est par exemple comprise entre 10 et 50 µm.

Au moins certains des éléments 24 sont connectés au réseau d'interconnexion 12 de la puce 2. Ces éléments 24 peuvent être connectés au plan métallique 40 de la puce 18, à la ou aux pistes conductrices formées dans la couche 38 de la puce 18 par l'intermédiaire de vias isolés non représentés traversant le plan métallique 40 de la puce 18, ou au réseau d'interconnexion 36 de la puce 18 par l'intermédiaire de vias isolés non représentés traversant le plan métallique 40 et la couche 38 de la puce 18.

Au moins certains des éléments 28 sont connectés au réseau d'interconnexion 12 de la puce 2 par l'intermédiaire de vias 42 traversant la puce 2 depuis la seconde face 6 jusqu'au réseau 12. Ces éléments 28 peuvent être connectés au plan 40 de la puce 20, à la ou aux pistes conductrices de la couche 38 de la puce 20 par l'intermédiaire d'un via isolé non représenté traversant le plan métallique 40 de la puce 20, ou au réseau d'interconnexion 36 de la puce 20 par l'intermédiaire de vias isolés non représentés traversant le plan métallique 40 et la couche 38 de la puce 20.

Par souci de clarté, un seul via 42 a été représenté en figure 1. Cependant, il peut y en avoir autant que nécessaire.

La puce 18, dans l'exemple de la figure 1, a des dimensions inférieures aux dimensions de la puce 2 de manière à permettre l'accès aux plots de contact 14. Les dimensions de la puce 18 sont néanmoins au moins suffisantes pour recouvrir l'ensemble des composants à protéger 8 et le réseau d'interconnexion 12 les connectant.

La puce 20, dans l'exemple de la figure 1, a des dimensions sensiblement égales à celles de la puce 2. Les dimensions de la puce 20 peuvent néanmoins être différentes de celles de la puce 2, tout en restant suffisantes pour recouvrir l'ensemble des composants 8 à protéger.

A titre de variante, non représentée, il est possible pour les connexions faites par les fils conducteurs 16 d'être effectués de manière différente. Par exemple, les plots de contact 14 peuvent être situés sur la face de la puce 18 opposée au plan métallique 40 et la connexion avec la puce 2 peut alors être faite par l'intermédiaire d'éléments métalliques 24 et de vias traversant la puce 18 jusqu'aux plots de contact 14. La puce 18 peut alors avoir des dimensions sensiblement égales à celles de la puce 2.

La figure 2 est une vue en perspective, schématique et simplifiée, du mode de réalisation décrit en relation avec la figure 1 représentant un exemple de motif de piste conductrice. La puce 18 n'est représentée ici que par un plan 48 contenant une piste conductrice 43. De même, la puce 20 n'est représentée que par un plan 49 contenant une piste conductrice 43. La puce 2 est uniquement représentée par un parallélépipède.

Dans cet exemple, la piste conductrice 43 de chaque couche 38 a une forme de serpentin et a des extrémités 50 et 52. Les extrémités 50 des pistes sont connectées ensemble par une connexion 54. La connexion 54 correspond par exemple, en relation avec la figure 1, à un via isolé traversant le plan métallique 40 de la puce 18, à un élément métallique 24, au réseau d'interconnexion 12, à un via 42 traversant la puce 2, à un élément métallique 28 et à un autre via traversant le plan métallique 40 de la puce 20. Les pistes conductrices 43 et la connexion 54 forment donc un chemin continu électriquement allant d'une extrémité 52 à l'autre. Les extrémités 52 des pistes conductrices 43 sont connectées, par des connexions 56, à un dispositif, non représenté, adapté à détecter l'interruption du chemin continu électriquement, c'est-à-dire l'interruption totale ou partielle d'une des pistes conductrices 43 ou l'interruption d'une des connexions 54 ou 56. Le dispositif est situé parmi les composants à protéger (8, figure 1) de la puce 2. Ainsi, le dispositif est protégé des pirates qui ne peuvent alors pas interférer avec son fonctionnement, par exemple en le désactivant.

Les motifs des pistes conductrices sont des motifs serrés, c'est-à-dire que l'espacement entre deux portions voisines de piste conductrice est relativement faible. Le choix des dimensions des pistes et de l'espacement séparant des portions voisines de piste est fait en fonction des technologies de gravure existantes, de telle manière que toute tentative d'attaque par gravure entraine l'interruption totale ou partielle d'une piste conductrice.

Une étape de détection d'interruption des pistes conductrices 43 et de la connexion 54 peut par exemple être effectuée après une commande manuelle, de manière automatique à intervalles réguliers ou à chaque démarrage de la puce, lors de l'initialisation.

La figure 3 est une vue en perspective, schématique et simplifiée, d'une variante de réalisation. La figure représente un autre exemple de motif de piste conductrice. La figure 3 comprend des éléments identiques à des éléments de la figure 2, désignés par de mêmes références. La figure 3 représente un chemin électriquement continu débutant par la puce 2, où il est connecté à un dispositif, non représenté, de détection d'interruption du chemin. Le chemin alterne ensuite, par l'intermédiaire d'une connexion 56 et de connexions 54 décrites précédemment, entre des pistes conductrices 43 des puces 18 et 20 avant de rejoindre la puce 2 et le dispositif de détection par une connexion 56.

A titre de variante, il est possible de former plusieurs chemins continus électriquement distincts, chacun connecté à un dispositif adapté à détecter l'interruption du chemin et situé parmi les composants à protéger 8 de la puce 2. Par exemple, il est possible de former un chemin allant de la puce 2 à la couche 38 de la puce 18, s'étendant dans cette couche 38 et rejoignant la puce 2, ainsi qu'un chemin similaire pour la puce 20. Chacun de ces chemins permet de détecter le perçage de la puce, 18 ou 20, dans laquelle il est formé, ou sa séparation de la puce 2. Il n'y a alors pas de connexion directe (par exemple une connexion 54) entre les pistes de la puce 18 et de la puce 20.

Les attaques physiques telles que le perçage d'une des puces 18 ou 20, par exemple pour placer un contact au niveau du réseau d'interconnexion, peuvent atteindre les composants 34 et les réseaux d'interconnexion 36 de ladite puce 18 ou 20. Cependant les puces 18 et 20 ne contiennent pas de données confidentielles. Une telle attaque visant la puce 2, qui contient des données confidentielles, provoque une interruption totale ou partielle d'une piste conductrice d'une couche 38 et est détectée. Le retrait d'une des puces 18 et 20 de manière à avoir accès à la puce 2 provoque l'interruption d'une connexion 54 ou 56 et la détection de l'attaque.

Les attaques laser peuvent, comme les attaques physiques, atteindre les puces 18 et 20. Cependant, les plans métalliques 40 arrêtent le faisceau laser qui ne peut donc atteindre la puce 2. Les puces auxiliaires 18 et 20 peuvent aussi comprendre des détecteurs de faisceau laser, par exemple des photodiodes, de manière à repérer une attaque par faisceau laser. Les puces auxiliaires 18 et 20 peuvent aussi comprendre des dispositifs de protection supplémentaires.

Les plans métalliques 40 connectés à la masse, forment une cage de Faraday autour des composants 8. Il n'est donc pas possible pour un pirate d'analyser les émissions électromagnétiques de la puce 2.

Un avantage des modes de réalisation décrits précédemment est que la puce 2 que l'on cherche à protéger n'est pas modifiée par les dispositifs de protection.

A titre de variante qui ne fait pas partie de l'invention revendiquée, les plans métalliques 40 et les pistes conductrices 43, ainsi que les couches isolantes les séparant, peuvent ne pas être situées, comme dans la figure 1, dans des puces 18 et 20 différentes de la puce protégée 2, mais peuvent recouvrir les première et seconde faces de la puce 2, encadrant les composants 8.

Un avantage de ces modes de réalisation est que le détecteur d'interruption des pistes conductrices est parmi les composants 8 et est protégé. Il ne peut donc être atteint par le pirate.

Des modes de réalisation particuliers ont été décrits. Diverses variantes et modifications apparaîtront à l'homme de l'art. En particulier, d'autres motifs sont possibles pour les pistes conductrices 43 des couches 38. Les pistes conductrices 43 peuvent par exemple prendre la forme d'une ou plusieurs spirales ou la forme de lignes. Les motifs des pistes conductrices 43 d'une puce 18 ou 20 peuvent s'étendre sur plusieurs niveaux.

## Revendications

1. Empilement de puces comprenant :
une puce principale (2) contenant des composants à protéger (8) ; et
une puce auxiliaire (18, 20) en regard de chaque face (4, 6) de la puce principale (2), une zone de chaque puce auxiliaire en regard des composants à protéger (8) comprenant un plan métallique (40) connecté à la masse, et au moins une piste conductrice isolée (43) formant un motif serré en regard des composants à protéger (8), les extrémités (50, 52) de ladite au moins une piste conductrice étant accessibles au niveau de la puce principale (2), le plan métallique de chaque puce auxiliaire étant situé entre la puce principale et la piste conductrice de ladite puce auxiliaire.

2. Empilement de puces selon la revendication 1, dans lequel le motif formé par les pistes conductrices (43) est un serpentin.

3. Empilement de puces selon la revendication 1, dans lequel le motif formé par les pistes conductrices (43) est une spirale.

4. Empilement de puces selon l'une quelconque des revendications 1 à 3, dans lequel une extrémité (50) d'une piste conductrice (43) d'une puce auxiliaire (18, 20) est connectée à une extrémité (50) d'une piste conductrice (43) de l'autre puce auxiliaire (18, 20).

5. Empilement de puces selon la revendication 4, dans lequel les pistes conductrices (43) sont connectées à un dispositif adapté à détecter des interruptions des pistes conductrices (43).

6. Empilement de puces selon l'une quelconque des revendications 1 à 5, dans lequel le dispositif est adapté à détecter une interruption de la connexion (54, 56) entre les pistes conductrices (43).

7. Empilement de puces selon l'une quelconque des revendications 1 à 6, dans lequel les puces auxiliaires (18, 20) sont fixées à la puce principale (2) par des billes métalliques (24, 28).

8. Empilement de puces selon l'une quelconque des revendications 1 à 7, dans lequel les puces auxiliaires (18, 20) comprennent des composants électroniques (34).

9. Empilement de puces selon l'une quelconque des revendications 1 à 8, dans lequel le plan métallique (40) de chaque puce auxiliaire (18, 20) s'étend sur toute la surface de la puce auxiliaire correspondante.

10. Empilement de puces selon l'une quelconque des revendications 1 à 9, dans lequel les dimensions d'une des puces auxiliaires (18, 20) sont inférieures à celles de la puce principale(2).

11. Procédé de protection de composants (8) d'une puce principale (2) contenant des composants à protéger, le procédé comprenant les étapes suivantes :
prévoir des puces auxiliaires (18, 20) comprenant chacune un plan métallique (40) connecté à la masse, et au moins une piste conductrice isolée (43) formant un motif serré ;
monter les puces auxiliaires (18, 20) de part et d'autre de la puce principale (2) de telle manière que les plans métalliques (40) et les pistes conductrices (43) soient en regard des composants à protéger (8), le plan métallique de chaque puce auxiliaire étant situé entre la puce principale et la piste conductrice de ladite puce auxiliaire ; et
connecter les extrémités (50, 52) des pistes conductrices (43) avec la puce principale (2).

## Patentansprüche

1. Ein Chipstapel, der Folgendes aufweist:
einen Hauptchip (2), der Komponenten (8) enthält, die zu schützen sind, und
einen Hilfschip (18, 20) gegenüber jeder Oberfläche (4, 6) des Hauptchips (2), wobei ein Bereich jedes Hilfschips gegenüber den Komponenten (8), die zu schützen sind, eine Metallebene (40) aufweist, die mit Masse verbunden ist, und wenigstens eine isolierte leitende Bahn (43) aufweist, die ein dichtes Muster bildet, und zwar gegenüber den Komponenten (8), die zu schützen sind, wobei die Enden (50, 52) der wenigstens einen leitenden Bahn auf der Ebene des Hauptchips (2) zugänglich sind, wobei die Metallebene jedes Hilfschips angeordnet ist zwischen dem Hauptchip und der leitenden Bahn des Hilfschips.

2. Der Chipstapel nach Anspruch 1, wobei das Muster, dass durch die leitenden Bahnen (43) gebildet wird, schlangenförmig ist.

3. Der Chipstapel nach Anspruch 1, wobei das Muster, dass durch die leitenden Bahnen (43) gebildet wird, spiralförmig ist.

4. Der Chipstapel nach einem der Ansprüche 1 bis 3, wobei ein Ende (50) einer leitenden Bahn (43) eines Hilfschips (18, 20) verbunden ist mit einem Ende (50) einer leitenden Bahn (43) des anderen Hilfschips (18, 20).

5. Der Chipstapel nach Anspruch 4, wobei die leitenden Bahnen (43) mit einer Vorrichtung verbunden sind, die in der Lages ist, Unterbrechungen der leitenden Bahnen (43) zu detektieren.

6. Der Chipstapel nach einem der Ansprüche 1 bis 5, wobei die Vorrichtung in der Lages ist, eine Unterbrechung der Verbindung (54, 56) zwischen den leitenden Bahnen (43) zu detektieren.

7. Der Chipstapel nach einem der Ansprüche 1 bis 6, wobei die Hilfschips (18, 20) an dem Hauptchip (2) durch Metallhöcker (24, 28) befestigt sind.

8. Der Chipstapel nach einem der Ansprüche 1 bis 7, wobei die Hilfschips (18, 20) elektronische Komponenten (34) aufweisen.

9. Der Chipstapel nach einem der Ansprüche 1 bis 8, wobei sich die Metallebene (40) jedes Hilfschips (18, 20) über die gesamte Oberfläche des entsprechenden Hilfschips erstreckt.

10. Der Chipstapel nach einem der Ansprüche 1 bis 9, wobei die Abmessungen eines der Hilfschips (18, 20) kleiner sind als die des Hauptchips (2).

11. Ein Verfahren zum Schützen von Komponenten (8) eines Hauptchips (2), der Komponenten (8) enthält, die zu schützen sind, wobei das Verfahren die folgenden Schritte aufweist:
Bereitstellen von Hilfschips (18, 20), die jeweils eine Metallebene (40) aufweisen, die mit Masse verbunden ist, und wenigstens eine isolierte leitende Bahn (43) aufweisen, die ein dichtes Muster bildet;
Montieren der Hilfschips (18, 20) auf jeder Seite des Hauptchips (2), so dass die Metallebenen (40) und die leitenden Bahnen (43) gegenüber den zu Komponenten (8), die zu schützen sind, liegen; und
Verbinden der Enden (50, 52) der leitenden Bahnen (43) mit dem Hauptchip (2).

## Claims

1. A chip stack comprising:
a main chip (2) containing components to be protected (8); and
an auxiliary chip (18, 20) opposite each surface (4, 6) of the main chip (2), an area of each auxiliary chip opposite the components to be protected (8) comprising a metal plane (40) connected to ground, and at least one insulated conductive track (43) forming a tight pattern opposite the components to be protected (8), the ends (50, 52) of said at least one conductive track being accessible at the level of the main chip (2), the metal plane of each auxiliary chip being located between the main chip and the conductive track of said auxiliary chip.

2. The chip stack of claim 1, wherein the pattern formed by the conductive tracks (43) is serpentine shaped.

3. The chip stack of claim 1, wherein the pattern formed by the conductive tracks (43) is a spiral.

4. The chip stack of any of claims 1 to 3, wherein one end (50) of a conductive track (43) of an auxiliary chip (18, 20) is connected to an end (50) of a conductive track (43) of the other auxiliary chip (18, 20).

5. The chip stack of claim 4, wherein the conductive tracks (43) are connected to a device capable of detecting interruptions of the conductive tracks (43).

6. The chip stack of any of claims 1 to 5, wherein the device is capable of detecting an interruption of the connection (54, 56) between the conductive tracks (43).

7. The chip stack of any of claims 1 to 6, wherein the auxiliary chips (18, 20) are affixed to the main chip (2) by metal bumps (24, 28).

8. The chip stack of any of claims 1 to 7, wherein the auxiliary chips (18, 20) comprise electronic components (34).

9. The chip stack of any of claims 1 to 8, wherein the metal plane (40) of each auxiliary chip (18, 20) extends over the entire surface of the corresponding auxiliary chip.

10. The chip stack of any of claims 1 to 9, wherein the dimensions of one of the auxiliary chips (18, 20) are smaller than those of the main chip (2).

11. A method of protecting components (8) of a main chip (2) containing components to be protected (8) comprising the steps of:
providing auxiliary chips (18, 20) each comprising a metal plane (40) connected to ground, and at least one insulated conductive track (43) forming a tight pattern;
assembling the auxiliary chips (18, 20) on either side of the main chip (2) so that the metal planes (40) and the conductive tracks (43) are opposite the components to be protected (8); and
connecting the ends (50, 52) of the conductive tracks (43) to the main chip (2).
